# EUROPEAN PATENT APPLICATION

(11) **EP 3 091 584 A1**
(43) Date of publication of application: **09.11.2016**
(21) Application number: 14876450.9
(22) Date of filing: 31.12.2014
(51) Int. Cl.: H01L 31/18, H01L 31/0445

(54) **DEVICE FOR MANUFACTURING INTEGRATED THIN FILM SOLAR CELL**

(30) Priority: 31.12.2013 KR 20130168007
(71) Applicant: Korea Advanced Institute Of Science And Technology, Daejeon 305-701 (KR)
(72) Inventor: LIM, Koeng Su, Daejeon 305-701 (KR); JEON, Jin Wan, Daejeon 305-701 (KR); HONG, Yun Ho, Daejeon 305-701 (KR)
(74) Representative: Patronus IP Patent- und Rechtsanwälte
(86) International application number: PCT/KR2014/013119
(87) International publication number: WO 2015/102409

(57) **Abstract**

An apparatus for manufacturing an integrated thin film solar cell in which a plurality of unit cells are electrically connected in series to each other in vacuum may be provided that includes: a photoelectric converter forming process chamber which forms a photoelectric converter by emitting a photoelectric conversion material on a substrate where a first conductive layer has been formed from one basic line within each of a plurality of trenches formed in the substrate to a bottom of each of the trenches, to one side continuous from the bottom, and to a protruding surface of the substrate, which is continuous from the one side; and a second conductive layer forming process chamber which forms a second conductive layer from another basic line within each of the trenches to the bottom of each of the trenches, to the other side continuous from the bottom, and to a protruding surface of the substrate, which is continuous from the other side. The photoelectric converter forming process chamber and the second conductive layer forming process chamber perform the respective processes in vacuum.

## Description

### TECHNICAL FIELD

The present invention relates to apparatuses for manufacturing integrated thin film solar cells.

### BACKGROUND ART

Generally, a solar cell is a device which converts sunlight energy into electric energy by using a photovoltaic effect caused by a junction of a p-type semiconductor and an n-type semiconductor, that is, a semiconductor p-n junction, by a junction of metal and semiconductor, that is, a metal/semiconductor (MS) junction (what is called, Schottky junction), or by a metal/insulator/semiconductor (MIS) junction.

Based on a material used for the solar cell, the solar cell is largely divided into a silicon based solar cell, a compound based solar cell, and an organic based solar cell. According to a semiconductor phase, the silicon based solar cell is divided into a single crystalline silicon (sc-Si) solar cell, a polycrystalline silicon (pc-Si) solar cell, a microcrystalline silicon (µc-Si:H) solar cell, and an amorphous silicon (a-Si:H) solar cell. In addition, based on the thickness of a semiconductor, the solar cell is divided into a bulk solar cell and a thin film solar cell. The thin film solar cell has a semiconductor layer with a thickness less than from several µm to several tens of µm. In the silicon based solar cell, the single crystalline silicon solar cell and the polycrystalline silicon solar cell are included in the bulk solar cell. The amorphous silicon solar cell and the microcrystalline silicon solar cell are included in the thin film solar cell. The compound based solar cell is divided into a bulk solar cell and a thin film solar cell. The bulk solar cell includes Gallium Arsenide (GaAs) and Indium Phosphide (InP) of group III-V. The thin film solar cell includes Cadmium Telluride (CdTe) of group II-VI and Copper Indium Gallium Diselenide (CIGS) (CulnGaSe₂) of group I-III-VI. The organic based solar cell is largely divided into an organic molecule type solar cell and an organic and inorganic complex type solar cell. In addition, there are a dye-sensitized solar cell and a perovskite based solar cell. All of the organic based solar cell, the dye-sensitized solar cell, and the perovskite based solar cell are included in the thin film solar cell.

Among the various kinds of solar cells, the bulk silicon solar cell having a high energy conversion efficiency and a relatively low manufacturing cost is being widely and generally used for a ground power. However, since a wafer, i.e., a substrate occupies a very large proportion of the manufacturing cost of the bulk silicon solar cell, research is being actively conducted to reduce the thickness of the silicon substrate. Also, regarding the bulk solar cell of group III-V, research is being conducted to form the thin film solar cell on an inexpensive substrate. Meanwhile, a thin film silicon solar cell manufacturing technology has been developing, which is capable of simply and inexpensively producing a large area solar cell which uses a small amount of material and is based on amorphous silicon on the inexpensive substrate, e.g., glass or stainless steel. Also, regarding the thin film solar cell like the Copper Indium Gallium Diselenide (CIGS) solar cell, an attempt is being made to reduce the cost of the solar cell by manufacturing the integrated CIGS solar cell through use of a thin and flexible substrate made of polyimide, stainless steel, molybdenum or the like. Moreover, there is an urgent requirement for the development of a method of manufacturing a flexible see-through type integrated thin film solar cell, for the purpose of various applications. The thin film solar cell must be integrated in order to obtain a practical high voltage. The integrated thin film solar cell is basically composed of unit solar cells, that is, unit cells. Adjacent unit cells are electrically connected in series to each other. For the purpose of the manufacture of the integrated thin film solar cell with such a structure, multi-step film formation (or deposition) and scribing (or patterning) processes should be performed and various apparatus should be used in each of the scribing or patterning processes in accordance with purposes.

A representatively commercialized integration technology is laser patterning. In the manufacture of the integrated thin film solar cell through use of a glass substrate in accordance with the laser patterning, the laser patterning process is required to be performed three times in total in order to scribing a first conductive layer (a transparent conductive layer or metal), a photoelectric converter, a second conductive layer (a metal or transparent conductive layer), etc., respectively. Through the laser patterning process performed three times, an effective area functioning as the integrated thin film solar cell is reduced by as much as several percent. There is a problem that since the effective area is reduced by as much as several percent, electric power that can be generated by the entire integrated thin film solar cell is reduced by the reduction of the effective area. Also, in the manufacture of the integrated thin film solar cell, due to the laser patterning process that should be performed in the air, it is almost impossible to continuously perform the deposition process in vacuum.

Also, in the manufacture of the integrated thin film solar cell, since the deposition process cannot be continuously performed in vacuum, there is a requirement for a complex process in which the substrate comes in and out between the vacuum and the air. Accordingly, it is difficult to manufacture the integrated thin film solar cell with a multi-junction structure as well as the integrated thin film solar cell with a single-junction structure.

Also, in the manufacture of the integrated thin film solar cell, since the scribing process is performed in the air by laser in most cases, each layer of the solar cell is contaminated by moisture, dust, etc., in the air, so that the interface properties of the device are deteriorated. Therefore, the energy conversion efficiency of the device is degraded.

Also, in the manufacture of the integrated thin film solar cell, fine holes, i.e., pin holes are formed in the thin film by the dust generated by the laser scribing, so that a shunt resistance is reduced, and the thin film is thermally damaged by the laser energy. Accordingly, the film characteristics are deteriorated and the junction characteristics of the device are deteriorated. As a result, the energy conversion efficiency of the device is degraded.

Also, in the manufacture of the integrated thin film solar cell, for the purpose of the countermeasures against the dust, there are requirements for a substrate inverter, a substrate cleaner, and several expensive laser apparatuses. As a result, the manufacturing cost of the integrated thin film solar cell rises.

Also, in the manufacture of the integrated see-through type thin film solar cell by the laser patterning technology, the integrated see-through type thin film solar cell becomes more expensive.

### DISCLOSURE

### Technical Problem

The object of the present invention is to provide an apparatus capable of manufacturing an integrated thin film solar cell which maximizes the effective area by performing repeatedly or continuously only a deposition process in a plurality of vacuum process chambers or by performing repeatedly or continuously the deposition process and an etching process in the plurality of vacuum process chambers, thereby maximizing the electric power production.
The object of the present invention is to provide an apparatus capable of easily manufacturing the integrated thin film solar cell with a multi-junction structure as well as a single-junction structure in the plurality of vacuum process chambers.

The object of the present invention is to provide an apparatus capable of manufacturing the integrated thin film solar cell which has a high efficiency without breaking the vacuum in order to fundamentally solve a problem that, whenever a substrate on which each thin film has been deposited is exposed to the air so as to perform a laser patterning process, each layer of the solar cell is contaminated by moisture, dust, etc., in the air, so that the interface properties of a device are deteriorated, and thus, the energy conversion efficiency of the device is degraded.

The object of the present invention is to provide an apparatus capable of manufacturing the integrated thin film solar cell which has a high efficiency without using laser in order to fundamentally solve a problem that fine holes, i.e., pin holes are formed in the thin film by the dust generated by the laser, so that then a shunt resistance is reduced, and the thin film is thermally damaged by the laser energy, so that the film characteristics are deteriorated and the junction characteristics of the device are deteriorated, and thus, the energy conversion efficiency of the device is degraded. The object of the present invention is to provide an apparatus capable of manufacturing the integrated thin film solar cell which is able to fundamentally solve a problem that a substrate inverter, a substrate cleaner, and several expensive laser apparatuses are required for the purpose of the countermeasures against the dust in the manufacture of the integrated thin film solar cell, so that the manufacturing cost of the integrated thin film solar cell rises.

The object of the present invention is to provide an apparatus capable of manufacturing the integrated see-through type thin film solar cell which is able to fundamentally solve a problem that the integrated see-through type thin film solar cell becomes more expensive in the manufacture of the integrated see-through type thin film solar cell by the laser patterning technology.

### Technical Solution

One embodiment of the present invention is an apparatus for manufacturing an integrated thin film solar cell in which a plurality of unit cells are electrically connected in series to each other in vacuum. The apparatus may include: a photoelectric converter forming process chamber which forms a photoelectric converter by emitting a photoelectric conversion material on a substrate where a first conductive layer has been formed from one basic line within each of a plurality of trenches formed in the substrate to a bottom of each of the trenches, to one side continuous from the bottom, and to a protruding surface of the substrate, which is continuous from the one side; and a second conductive layer forming process chamber which forms a second conductive layer from another basic line within each of the trenches to the bottom of each of the trenches, to the other side continuous from the bottom, and to a protruding surface of the substrate, which is continuous from the other side. The photoelectric converter forming process chamber and the second conductive layer forming process chamber perform the respective processes in vacuum.

### Advantageous Effects

According to the embodiment of the present invention described above, it is possible to manufacture an integrated thin film solar cell which maximizes the effective area by performing repeatedly or continuously only a deposition process in a plurality of vacuum process chambers or by performing repeatedly or continuously the deposition process and an etching process in the plurality of vacuum process chambers, thereby maximizing the electric power production. According to the embodiment of the present invention, it is possible to manufacture the integrated thin film solar cell with a multi-junction structure as well as a single-junction structure in the plurality of vacuum process chambers.

According to the embodiment of the present invention, it is possible to manufacture the integrated thin film solar cell which has a high efficiency without breaking the vacuum in order to fundamentally solve a problem that, whenever a substrate on which each thin film has been deposited is exposed to the air so as to perform a laser patterning process, each layer of the solar cell is contaminated by moisture, dust, etc., in the air, so that the interface properties of a device are deteriorated, and thus, the energy conversion efficiency of the device is degraded.

According to the embodiment of the present invention, it is possible to manufacture the integrated thin film solar cell which has a high efficiency without using laser in order to fundamentally solve a problem that fine holes, i.e., pin holes are formed in the thin film by the dust generated by the laser scribing, so that then a shunt resistance is reduced, and the thin film is thermally damaged by the laser energy, so that the film characteristics are deteriorated and the junction characteristics of the device are deteriorated, and thus, the energy conversion efficiency of the device is degraded.

According to the embodiment of the present invention, it is possible to manufacture the integrated high efficiency thin film solar cell which has a low manufacturing cost even without a substrate inverter, a substrate cleaner, and several expensive laser apparatuses for the purpose of the countermeasures against the dust.

According to the embodiment of the present invention, it is possible to manufacture the integrated see-through type thin film solar cell even without using an expensive laser apparatus. Details as well as the aforesaid technical solution, mode for invention and advantageous effects are included in the following detailed descriptions and drawings. The features, advantages and method for accomplishment of the present invention will be more apparent from referring to the following detailed embodiments described as well as the accompanying drawings. The same reference numerals throughout the disclosure correspond to the same elements.

### DESCRIPTION OF DRAWINGS

Fig. 1 shows an apparatus for manufacturing an integrated thin film solar cell according to a first embodiment of the present invention;
Fig. 2 shows an apparatus for manufacturing an integrated thin film solar cell according to a second embodiment of the present invention;
Fig. 3 shows a modified example of the apparatus for manufacturing the integrated thin film solar cell according to the second embodiment of the present invention;
Fig. 4 shows a modified example of the apparatus for manufacturing the integrated thin film solar cell according to the first embodiment of the present invention;
Figs. 5a to 5e show a manufacturing process of the integrated thin film solar cell which is manufactured by the integrated thin film solar cell manufacturing apparatuses of Figs. 1 to 4; and
Figs. 6a to 6b show an example of a process chamber of the integrated thin film solar cell manufacturing apparatus according to the embodiments of the present invention.

### MODE FOR INVENTION

An apparatus for manufacturing an integrated thin film solar cell in accordance with an embodiment of the present invention can be applied to the integration of all the dry-type thin film solar cells. However, for convenience, embodiments of the present invention will be described below in detail with reference to the accompanying drawings by taking an example of an amorphous silicon based-thin film silicon solar cell which has the most complex manufacturing process, includes the etching of a photoelectric converter. However, the accompanied drawings are provided only for more easily describing the present invention. It is easily understood by those skilled in the art that the spirit and scope of the present invention is not limited to the scope of the accompanied drawings.

An apparatus for manufacturing an integrated thin film solar cell according to embodiments of the present invention includes a second conductive layer forming process chamber P2. The second conductive layer forming process chamber P2 may include an emitter and a deposition angle adjuster. The emitter emits a second conductive material toward a substrate where the photoelectric converters spaced apart from each other have been sequentially stacked on first conductive layers spaced apart from each other in a vacuum state such that second conductive layers are formed, which are spaced apart from each other and are electrically connected to the adjacent first conductive layer within each trench between the adjacent photoelectric converters. The deposition angle adjuster adjusts the direction of the second conductive material emitted from the emitter. Here, the emitter refers to a device or a part, for example, a sputter gun, an effusion cell, an ion beam source, a neutral particle beam source, an electron beam evaporation source, a thermal evaporation source, a spray source, etc., which straightly emits radicals, ions, neutral particles of a material to be deposited. The deposition angle adjuster refers to a device, a part, or a structure, which causes a material that is evaporated to travel only in a preset direction or causes, like a shutter, the material that is evaporated to travel only in a desired direction by hiding a portion of the material. The structure mentioned herein may include a partition between the emitters or between the process chambers or include a portion of the structure of the process chamber. Therefore, in the latter case, there is no necessity of the device, the part, the partition, etc., which has a function of the shutter.

The apparatus for manufacturing an integrated thin film solar cell according to embodiments of the present invention may include not only the above-described second conductive layer forming process chamber P2 but also both a process chamber P1 which forms the photoelectric converter and a process chamber P3 which forms the first conductive layer. Also, the apparatus may further include a mask layer forming process chamber PA and an etching process chamber EP. The mask layer forming process chamber PA forms mask layers covering portions of the photoelectric converter. The etching process chamber EP etches the photoelectric converter exposed without being covered with the mask layers.

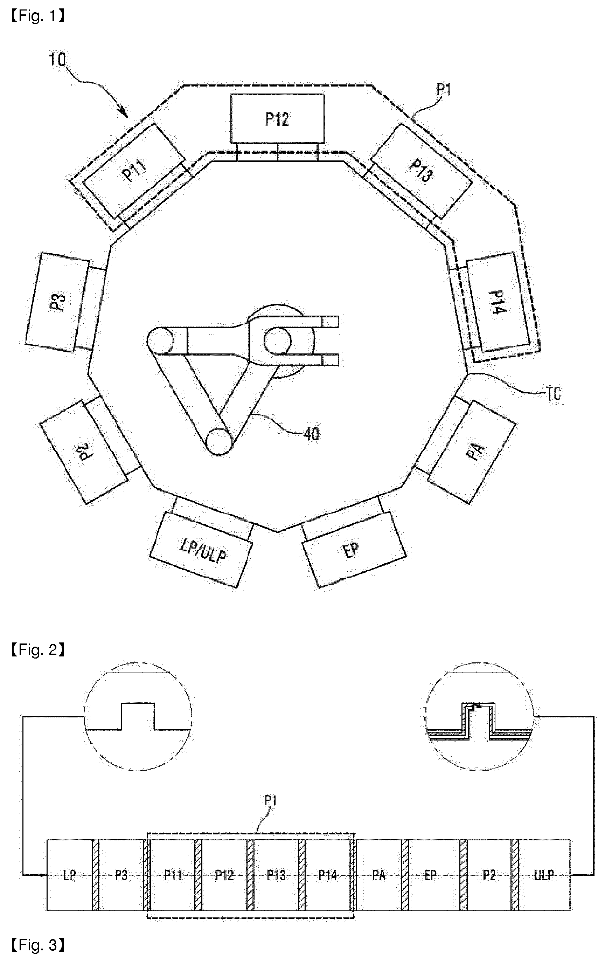

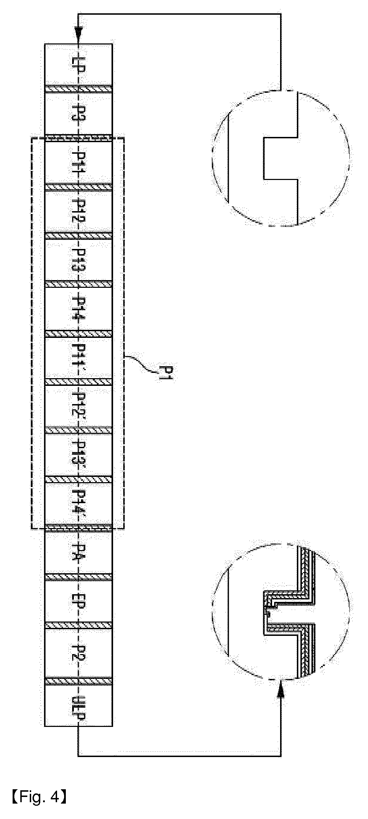

As shown in Figs. 1 and 4, when the integrated thin film solar cell manufacturing apparatus according to the embodiments of the present invention is an inline type manufacturing apparatus in a cluster method, the apparatus may further include a transfer chamber TC including a transfer part 40 for carrying the substrate into and out of each of the process chambers in vacuum, as it were, for transferring the substrate in vacuum. Also, the second conductive layer forming process chamber P2 may further include a substrate holder which receives the substrate from the transfer part 40. The apparatus may further include a loading/unloading chamber LP/ULP which combines the function of a loading chamber LP putting the substrate in the air into the inside of the vacuum apparatus with the function of an unloading chamber ULP taking out the substrate to the outside air from the inside of the vacuum apparatus. Otherwise, the apparatus may further include the loading chamber LP and the unloading chamber ULP which are separated from each other.

Also, as shown in Figs. 2 and 3, when the integrated thin film solar cell manufacturing apparatus according to the embodiments of the present invention is an inline type manufacturing apparatus in a roll-to-roll method or in a roller method, the apparatus may include the loading chamber LP and the unloading chamber ULP which have been equipped with an unwinding roller UWR (not shown) and a rewinding roller RWR (not shown) respectively. A flexible substrate is wound on a core of the unwinding roller UWR and is mounted in the loading chamber LP. During the process, the substrate is moved continuously by a drive means (not shown) and is wound on a core of the rewinding roller RWR mounted in the unloading chamber ULP. Therefore, in this case, the apparatus may not include the substrate holder and the transfer chamber TC including the separate transfer part 40.

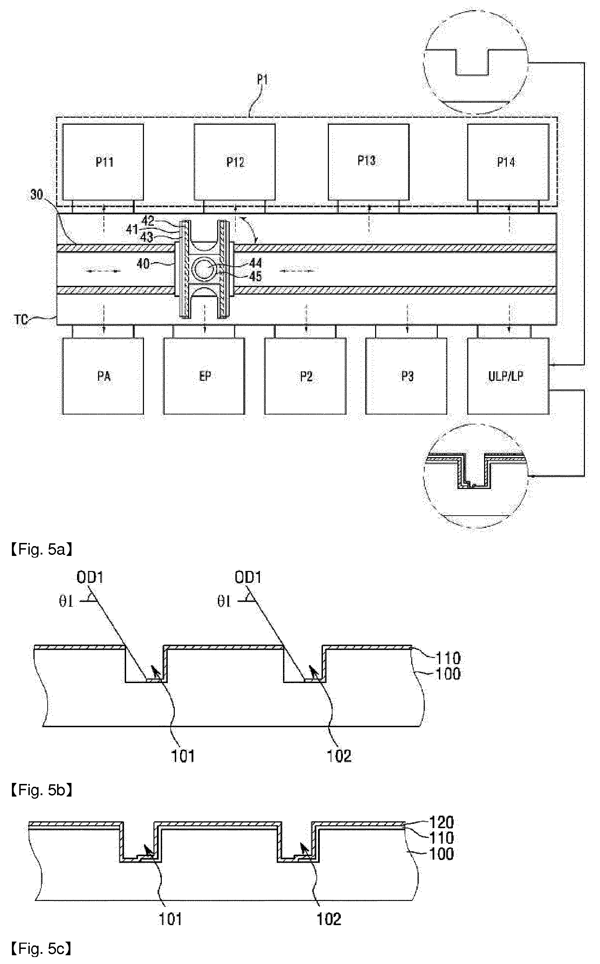

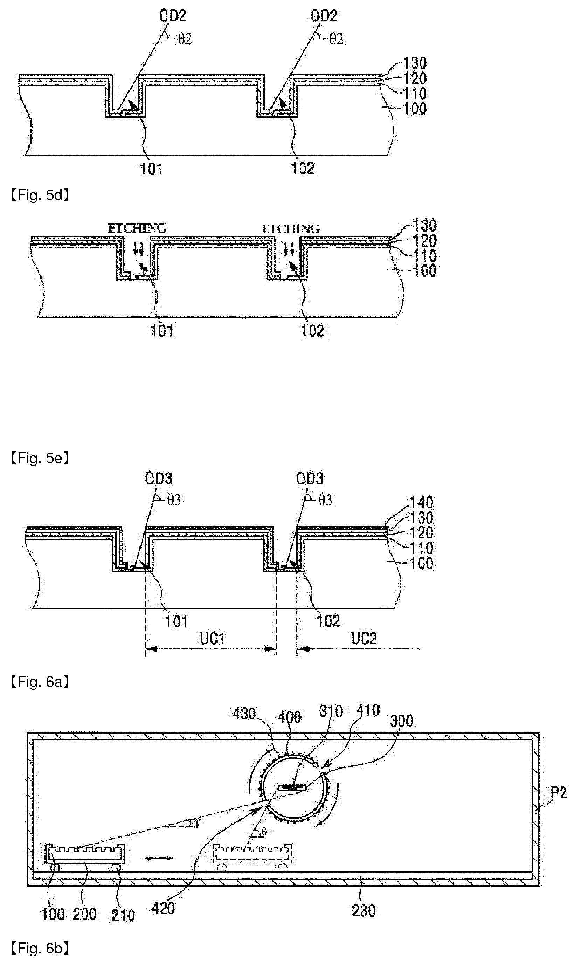

Fig. 1 shows the apparatus for manufacturing an integrated thin film solar cell according to a first embodiment of the present invention. Fig. 1 shows an inline type manufacturing apparatus in a cluster method. The cluster type apparatus 10 according to the first embodiment of the present invention includes, as shown in Fig. 1, the photoelectric converter forming process chamber P1 (P11 to P14), the process chambers PA, EP, and P2, the first conductive layer forming process chamber P3, and loading/unloading chambers LP/ULP. They are all arranged radially around the transfer chamber TC. In the photoelectric converter forming process chamber P1, the photoelectric converter is formed on the substrate on which the first conductive layers spaced apart from each other have been formed. Here, trenches are formed separately from each other in the substrate. This is, for example, represented by reference numerals 101 and 102 in Fig. 5. In the mask layer forming process chamber PA, the mask layers are formed by depositing a material for a mask on the substrate where the photoelectric converter has been formed. Specifically, the material for a mask is deposited from the other side obliquely with respect to the substrate, so that the mask layers are formed. Here, the other side means, as described with reference to Figs. 5a to 5e, the opposite side to one side from which a first conductive material is emitted. In the etching process chamber EP, the photoelectric converter which is exposed within the trenches by not being covered with the mask layers is etched by using the mask layers as a mask, such that a portion of the first conductive layer within the trenches covered with the photoelectric converter is exposed. In the second conductive layer forming process chamber P2, the second conductive layer is formed by depositing the second conductive material on the substrate where the above process has been performed. Specifically, the second conductive material is deposited from the other side obliquely with respect to the substrate, so that the second conductive layer is formed. These processes are sequentially performed in vacuum, so that the integrated thin film solar cell with a single-junction structure can be manufactured (see US Patent Numbers 8,148,626 and 8,153,885, US Patent Number 8,168,882, Japanese Patent Number 4,592,676, and Japanese Patent Number 5,396,444).

Also, the photoelectric converter forming process chamber P1 may form the photoelectric converter and may include one or more unit process chambers P11, P12, P13, and P14. Here, when a silicon based photoelectric converter is manufactured in the integrated thin film solar cell manufacturing apparatus according to the embodiments of the present invention, the photoelectric converter forming process chamber P1 may include a plurality of the unit process chambers P11, P12, P13, and P14 which form the first impurity semiconductor layer P11, intrinsic semiconductor layers P12 and P13, and the second impurity semiconductor layer P14. As described above, when the substrate is transferred between two process chambers among the plurality of process chambers P11 to P14, PA, EP, and P2 by the transfer part 40, the vacuum state is maintained. The first conductive material, the material for a mask, and the second conductive material may be made of a transparent conductive material or an opaque or highly transparent metallic material. The transparent conductive material is mainly a transparent conductive oxide (TCO). The transparent conductive material may include at least one of zinc oxide (ZnO), tin oxide (SnO₂), indium tin oxide (ITO), tungsten oxide (WO₃), molybdenum oxide (MoO₃), vanadium oxide (V₂O₅), titanium oxide (TiOₓ), or nickel oxide (NiOₓ). The opaque or highly transparent metallic material may include at least one of Al, Cu, Au, Ag, Zn, W, Ni, Cr, Mo, Ti, Cs, and Pt. The material for a mask may be made of an insulating material, for example, lithium fluoride (LiF). Here, the highly transparent metallic material refers to a metallic material having a thickness of approximately less than ten nanometers. Such first conductive material, the material for a mask, and the second conductive material can be applied to the following embodiment.

Fig. 1 shows one loading/unloading chamber LP/ULP. However, there is no limit to this, and the loading chamber LP and the unloading chamber ULP may be connected to the transfer chamber TC separately from each other. The loading chamber LP and the unloading chamber ULP may further include the substrate holder which receives the substrate from the transfer part 40. A plurality of the transfer parts 40 may be disposed within the transfer chamber TC. The transfer parts 40 is able to transfer the substrate straight or up and down or to rotate the substrate. The substrate where the first conductive layers spaced apart from each other have been formed is loaded within the apparatus through the loading/unloading chamber LP/ULP and is placed on the transfer part 40, and then is transferred to any one unit process chamber among the photoelectric converter forming process chambers P1. Here, the used substrate may be an insulation substrate or a substrate obtained by coating an insulating material on a conductive substrate. The trenches may be formed in the substrate in such a manner as to be spaced apart from each other at a regular interval and to be in parallel with each other.

Light is incident on and absorbed in the photoelectric converter, so that any material may be formed, which generates free carriers. For example, the photoelectric converter may be made of at least one of a silicon based material, a compound based material, an organic based material, a dry-type dye-sensitized based material, and a perovskite based material. Regarding a silicon based solar cell based on thin film silicon among them, any one of single-junction solar cells made of amorphous silicon, amorphous silicon-germanium (a-SiGe:H), microcrystalline silicon, and polycrystalline silicon, double-junction solar cells made of amorphous silicon/amorphous silicon, amorphous silicon/amorphous silicon-germanium, amorphous silicon/microcrystalline silicon, and amorphous silicon/polycrystalline silicon, triple-junction solar cells made of amorphous silicon/amorphous silicon-germanium/amorphous silicon-germanium, amorphous silicon/amorphous silicon-germanium/microcrystalline silicon, and amorphous silicon/microcrystalline silicon/microcrystalline silicon may be used as the silicon based solar cell based on thin film silicon. However, there is no limit to this. Also, the photoelectric converter may have a single-junction structure such as pn, pin, MS or MIS or may have a multi-junction structure through a combination of at least two of them.

Hereinafter, the following description will be provided by taking an example in which the photoelectric converter is based on the amorphous silicon. In this case, the photoelectric converter may be formed to have a single-junction structure including the first impurity semiconductor layer, the intrinsic (i) semiconductor layer, and the second impurity semiconductor layer. Also, the photo-electric converter may be formed to have a multi-junction structure including at least two single-junction structures based on the amorphous silicon.

In the first impurity semiconductor layer forming unit process chamber P11 of the photoelectric converter forming process chamber P1, the first impurity semiconductor layer with the addition of a first impurity is formed. Here, for the purpose of the deposition of the first impurity semiconductor layer, silane gas (SiH₄), hydrogen gas (H₂) and first impurity gas are introduced into the unit process chamber P11. When the first impurity gas is B₂H₆ gas for supplying a group III element like boron (B), a p-type semiconductor layer is formed. Also, when the first impurity gas is PH₃ gas for supplying a group V element like phosphorus (P), an n-type semiconductor layer is formed.

The thickness of the first impurity semiconductor layer may be less than that of the intrinsic semiconductor layer. Accordingly, a time required for forming the intrinsic semiconductor layer may be greater than a time required for forming the first impurity semiconductor layer. Therefore, in order to reduce manufacturing process time, the manufacturing apparatus according to the embodiment of the present invention may include one or more unit process chambers P12 and P13 in which the intrinsic semiconductor layer is formed.

The substrate where the first impurity semiconductor layer has been formed in the first impurity semiconductor layer forming unit process chamber P11 is transferred to the inside of an intrinsic semiconductor layer forming unit process chamber P12, and then the intrinsic semiconductor layer is formed on the substrate where the first impurity semiconductor layer has been formed. In the above unit process chamber P11, the first impurity semiconductor layer may be formed on another substrate. The another substrate where the first impurity semiconductor layer has been formed in the first impurity semiconductor layer forming unit process chamber P11 is transferred to the inside of another intrinsic semiconductor layer forming unit process chamber P13, and then the intrinsic semiconductor layer may be formed on the corresponding substrate.

During a period of time when the first impurity semiconductor layer is formed in the first impurity semiconductor layer forming unit process chamber P11 in such a manner, the process of forming the intrinsic semiconductor layer may be continuously performed in the intrinsic semiconductor layer forming unit process chambers P12 and P13. As a result, a tact time is shortened, and thus, the number of the produced solar cells can be increased within a certain period of time. The silane gas and hydrogen gas are introduced into the unit process chambers P12 and P13 in order to form the intrinsic semiconductor layer.

The substrate where the intrinsic semiconductor layer has been formed in the intrinsic semiconductor layer forming unit process chambers P12 and P13 is transferred to the second impurity semiconductor layer forming unit process chamber P14, and then the second impurity semiconductor layer is formed on the substrate where the intrinsic semiconductor layer has been formed. Second impurity gas as well as the silane gas and the hydrogen gas is introduced in order that the second impurity semiconductor layer is formed. When the first impurity semiconductor layer is a p-type semiconductor layer, the second impurity may be intended to supply a group V element. Also, when the first impurity semiconductor layer is an n-type semiconductor layer, the second impurity may be intended to supply a group III element.

Meanwhile, regarding the integrated thin film solar cell manufacturing apparatus, the method in which the first impurity semiconductor layer, the intrinsic semiconductor layer, and the second impurity semiconductor layer, which form the photoelectric converter, are formed in the above-described unit process chamber P11, the unit process chambers P12 and P13, and the unit process chamber P14 respectively has been described as an example. However, there is no limit to this, and there may be various methods as follows. In other words, the first impurity semiconductor layer, the intrinsic semiconductor layer, and the second impurity semiconductor layer may be formed in the one unit process chamber P11. Also, first impurity semiconductor layer and the second impurity semiconductor layer may be formed in the one unit process chamber P11, and the intrinsic semiconductor layer may be formed in the plurality of unit process chambers P12, P13, and P14. Also, the first impurity semiconductor layer and the intrinsic semiconductor layer may be formed in the one unit process chamber P11, and the second impurity semiconductor layer may be formed in another unit process chamber P12. Also, the first impurity semiconductor layer may be formed in the one unit process chamber P11, and the intrinsic semiconductor layer and the second impurity semiconductor layer may be formed in another unit process chamber P12. Also, when the photoelectric converter is formed of only the p-type semiconductor layer and the i-type semiconductor layer, the first impurity semiconductor layer, the intrinsic semiconductor layer, and the second impurity semiconductor layer may be formed in the unit process chamber P11 and in the unit process chamber P12 or P13 respectively. Also, when the photoelectric converter is formed of only the n-type semiconductor layer and the i-type semiconductor layer, the first impurity semiconductor layer, the intrinsic semiconductor layer, and the second impurity semiconductor layer may be formed in the unit process chamber P14 and in the unit process chamber P12 or P13 respectively. Also, when the photoelectric converter is the most simply formed of only the intrinsic semiconductor layer, the first impurity semiconductor layer, the intrinsic semiconductor layer, and the second impurity semiconductor layer may be formed in the unit process chamber P12 or P13. These methods of forming the photoelectric converter can be applied to not only the first embodiment but also to the following described embodiments.

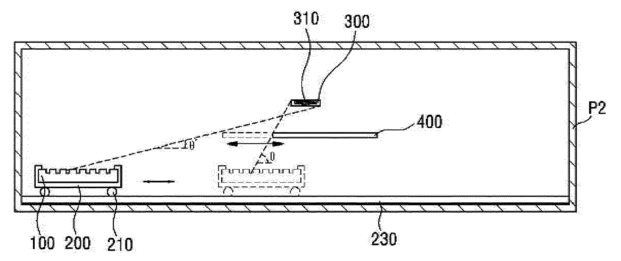

The substrate where the photoelectric converter has been formed on the first conductive layers spaced apart from each other is transferred in vacuum to the mask layer forming process chamber PA by the transfer part 40, and then the material for a mask is deposited from the other side obliquely with respect to the substrate, so that the mask layers are formed on the substrate where the photoelectric converter has been formed. The mask layers can be used as a mask for etching in the etching process chamber EP. As described above, the material for a mask may be made of a transparent conductive material, an opaque or highly transparent metallic material, or an insulating material. When the first conductive layer is made of the opaque metallic material, the mask layer made of the transparent conductive material or highly transparent metallic material may be formed on the photoelectric converter in the mask layer forming process chamber PA. Also, when the first conductive layer is made of the transparent conductive material, the mask layer made of the opaque or highly transparent metallic material or transparent conductive material may be formed on the photoelectric converter in the mask layer forming process chamber PA. The substrate where the mask layers have been formed in the mask layer forming process chamber PA is transferred in vacuum to the etching process chamber EP by the transfer part 40. The photoelectric converters exposed within the trenches, that is to say, the photoelectric converters spaced apart from each other formed by etching the second impurity semiconductor layer, the intrinsic semiconductor layer, and the first impurity semiconductor layer of the converter in turn by using the mask layers as a mask in the etching process chamber EP. Simultaneously with this, a portion of the first conductive layer located within the trench of the substrate is exposed. Here, even after the photoelectric converters within the trenches are completely etched by using a material having an etch rate less than that of the material of the photoelectric converter, the mask layer should cover the photoelectric converters in order that the photoelectric converters outside the trenches are not etched. Therefore, in consideration of this, it is necessary to control the thickness of the mask layer. The etching process may be performed by using a dry etching method such as reactive ion etching (RIE) using inductively coupled plasma (ICP). However, there is no limit to this. The substrate where the above etching process has been performed in the etching process chamber EP is transferred in vacuum to the second electrode layer forming process chamber P2 by the transfer part 40. The second electrode layer forming process chamber P2 will be described below in detail with reference to Figs. 6a and 6b. In the second electrode layer forming process chamber P2, the second conductive layer is formed by depositing the second conductive material on the substrate where the mask layers spaced apart from each other have been formed. Specifically, the second conductive material is deposited from the other side obliquely with respect to the substrate, so that the second conductive layer is formed. Here, the first conductive layer 110 formed in a first unit cell area (UC1 of Fig. 5e) and the second conductive layer 140 formed in a second unit cell area (UC2 of Fig. 5e) adjacent to the first unit cell area are electrically connected to each other within the trench between the first unit cell area and the second unit cell area. Accordingly, adjacent unit cells are electrically connected in series to each other, so that the integrated thin film solar cell is formed.

As described above, the second conductive material may be made of a transparent conductive material or an opaque or highly transparent metallic material. When the mask layer is made of an opaque or highly transparent metallic material in the mask layer forming process chamber PA, the second conductive layer may be made of an opaque or highly transparent metallic material. Also, when the mask layer is made of a transparent conductive material in the mask layer forming process chamber PA, the second conductive layer may be made of an opaque or highly transparent metallic material or a transparent conductive material.

In the integrated thin film solar cell manufacturing apparatus according to the embodiment of the present invention, the first conductive layer, the material for a mask, the second conductive layer are deposited by using a deposition method, for example, sputtering, ion-beam evaporation, neutral particle beam evaporation, electron beam evaporation, thermal evaporation, an effusion cell, spray, etc., which uses the straightness of a deposition material. However, there is no limit to this. The deposition method of the first conductive layer, the material for a mask, the second conductive layer can be applied to the following embodiments. Also, the transparent conductive material may be deposited in an atmosphere of oxygen (O₂).

Hereinafter, the following description will be provided by taking an example in which the second conductive layer is made of an opaque metallic material. The components of the second conductive material can be applied to the following described embodiments as well as the first embodiment.

As described above, after the substrate where the second conductive layer has been formed in the second conductive layer forming process chamber P2 is placed on the transfer part 40, the substrate is taken out from the integrated thin film solar cell manufacturing apparatus to the air through the loading/unloading chamber LP/ULP.

As described above, the first conductive layers spaced apart from each other are formed on the substrate where the trenches have been formed separately from each other at a regular interval and in parallel with each other. In this state, the formation of the photoelectric converter, the formation of the mask, the etching of the photoelectric converter, and the formation of the second conductive layer are performed in turn on the substrate. Accordingly, adjacent cells are electrically connected in series to each other, so that the integrated high efficiency thin film solar cell can be manufactured (see US Patent Numbers 8,148,626, 8,153,885, and 8,168,882).

Also, as shown in Fig. 1, the integrated thin film solar cell manufacturing apparatus according to the first embodiment of the present invention may further include another process chamber P3 forming the first conductive layer. In this case, the substrate, which has been loaded into the loading chamber LP and includes the mutually parallel trenches spaced apart at a regular interval, is transferred to the first conductive layer forming process chamber P3 by the transfer part 40. In the first conductive layer forming process chamber P3, the first conductive material is deposited on the substrate from one side obliquely with respect to the substrate, so that the first conductive layer is formed. As described above, the first conductive material may be made of a transparent conductive material or an opaque or highly transparent metallic material. When the substrate is made of a transparent insulating material and the first conductive layer is made of a transparent conductive material or a highly transparent metallic material, the light which has passed through the substrate may be incident on the first conductive layer made of a transparent conductive material or a highly transparent metallic material and then may transmit through the first conductive layer. Also, when the first conductive layer is made of an opaque metallic material, the mask layer and the second conductive layer are made of a transparent conductive material or a highly transparent metallic material, and then the light is incident on the second conductive layer.

As described above, on the substrate where the trenches have been formed separately from each other at a regular interval and in parallel with each other, the formation of the first conductive layer, the formation of the photoelectric converter, the formation of the mask layer, the etching of the photoelectric converter, and the formation of the second conductive layer are performed in turn. Accordingly, adjacent cells are electrically connected in series to each other, so that the integrated high efficiency thin film solar cell is manufactured.

Also, though not shown, two or more cluster type apparatuses having the same structure are connected to the cluster type apparatus shown in Fig. 1, so that it is possible to improve the productivity of the integrated solar cell.

The cluster type apparatus 10 shown in Fig. 1 may include unit process chambers P11' to P14' of a separate photoelectric converter forming process chamber P1' as well as the unit process chambers P11 to P14 of the photoelectric converter forming process chamber P1. However, the photoelectric converter forming process chamber P1 may simultaneously perform the function of the separate photoelectric converter forming process chamber P1', without including the separate photoelectric converter forming process chamber P1'. In these cases, it is possible to manufacture the integrated high efficiency thin film solar cell which has a double-junction structure formed by stacking the plurality of photoelectric converters with a single-junction structure while maintaining the vacuum state.

As described above, in the manufacture of the integrated thin film solar cell by the cluster type apparatus according to the first embodiment of the present invention, the integrated high efficiency thin film solar cell which has a single-junction structure or a multi-junction structure can be manufactured by performing repeatedly or continuously a deposition process and an etching process in the plurality of vacuum process chambers. Also, such a device manufacturing method can be applied to an inline type manufacturing apparatus in a roll-to-roll method or in a roller method. When the photoelectric converter is formed in the photoelectric converter forming process chamber P1 by using the above-described thin film deposition method such as sputtering, ion-beam evaporation, neutral particle beam evaporation, electron beam evaporation, thermal evaporation, an effusion cell, spray, etc., which uses the straightness of a deposition material, the material of the photoelectric converter may be obliquely deposited on the substrate in such a manner that a portion of the first conductive layer located within the trench is exposed. Therefore, since there is no need to etch the material of the photoelectric converter after the formation of the mask layer, the mask layer forming process chamber PA and the etching process chamber EP can be omitted. In this case, on the substrate where the trenches have been formed separately from each other at a regular interval and in parallel with each other, the formation of the first conductive layer, the formation of the photoelectric converter, and the formation of the second conductive layer are performed in turn. Accordingly, adjacent cells are electrically connected in series to each other, so that the integrated high efficiency thin film solar cell with a single-junction structure is manufactured (see Japanese Patent Number 5,396,444).

As described above, in the manufacture of the integrated thin film solar cell by the cluster type apparatus according to the first embodiment of the present invention, it is possible to manufacture the integrated high efficiency thin film solar cell which has a single-junction structure and maximizes the effective area by performing repeatedly or continuously only a deposition process in the plurality of vacuum process chambers. Also, such a device manufacturing method can be applied to an inline type manufacturing apparatus in a roll-to-roll method or in a roller method (see Japanese Patent Number 5,396,444). Hereinafter, such methods will be described.

As shown in Figs. 2 and 3, an integrated thin film solar cell manufacturing apparatus according to a second embodiment of the present invention and a modified example of the second embodiment is an inline type manufacturing apparatus in a roll-to-roll method or in a roller method. Such a type of manufacturing apparatus includes the photoelectric converter forming process chamber P1 including one or more unit process chambers P11, P12, P13, and P14, the mask layer forming process chamber PA, the etching process chamber EP, the second electrode layer forming process chamber P2, the first electrode layer forming process chamber P3, the loading chamber LP, and the unloading chamber ULP. The functions of the chambers are the same as those described in the first embodiment respectively. Therefore, a detailed description thereof will be omitted.

Fig. 2 shows an apparatus for manufacturing an integrated thin film solar cell with a single-junction structure according to the second embodiment of the present invention and shows an inline type manufacturing apparatus in a roll-to-roll method or in a roller method. In such an apparatus, a flexible substrate where the trenches have been formed is wound on a core of the unwinding roller UWR (not shown) and is mounted within the loading chamber LP on the left side. Then, during the process, the substrate is continuously moved by a drive means (not shown) and is wound on a core of the rewinding roller RWR (not shown) mounted within the unloading chamber ULP on the right side, while passing in turn through the plurality of chambers such as the first conductive layer forming process chamber P3, the photoelectric converter forming unit process chambers P11 to P14, the mask layer forming process chambers PA, the etching process chamber EP, the second conductive layer forming process chamber P2, etc. In other words, on the substrate where the trenches have been formed separately from each other, a series of processes including the formation of the first conductive layer by the oblique deposition, the formation of the photoelectric converter, the formation of the mask layer by the oblique deposition, the etching of the photoelectric converter, and the formation of the second conductive layer by the oblique deposition, etc., are continuously performed in vacuum. As a result, the integrated high efficiency thin film solar cell with a single-junction structure is manufactured in vacuum without using laser. Also, in this case, unlike the cluster type manufacturing apparatus described in Fig. 1, the integrated thin film solar cell manufacturing apparatus of Fig. 2 may not include the substrate holder and the transfer chamber including the separate transfer part 40, and instead may include the loading chamber LP and the unloading chamber ULP which have been equipped with an unwinding roller UWR and a rewinding roller RWR respectively. Also, such a device manufacturing method can be applied to a modified example of the second embodiment shown in Fig. 3 as well as the second embodiment shown in Fig. 2.

In the unit process chambers P12 and P13 shown in Fig. 1, the same intrinsic semiconductor material (for example, amorphous silicon) can be simultaneously deposited on two substrates respectively, or different intrinsic semiconductor materials (for example, amorphous silicon and microcrystalline silicon) can be simultaneously deposited. Unlike this, in the unit process chambers P12 and P13 shown in Figs. 2 and 3, the same intrinsic semiconductor material can be continuously deposited on the same substrate.

Fig. 3 shows an integrated thin film solar cell manufacturing apparatus with a double-junction structure according to a modified example of the second embodiment of the present invention and shows an inline type manufacturing apparatus in a roll-to-roll method or in a roller method. Such an apparatus includes, as shown in Fig. 3, not only one or more unit process chambers P11 to P14 forming the first photoelectric converter but also one or more unit process chambers P11' to P14' forming the second photoelectric converter on the substrate where the first photoelectric converter has been formed. The plurality of unit process chambers P11' to P14' forming the second photoelectric converter may be connected between the unit process chamber P14 and the mask layer forming process chamber PA forming the mask layer.

As described with reference to the first embodiment, the integrated thin film solar cell manufacturing apparatuses according to the second embodiment and the modified example of the second embodiment shown in Figs. 2 and 3 also may or may not include the first conductive layer forming process chamber P3 respectively. When the roll-to-roll type or roller type manufacturing apparatus does not include the first conductive layer forming process chamber P3, the substrate where the first conductive layers spaced apart from each other have been formed may be transferred to the unit process chamber P11 of the process chamber P1 through the loading chamber LP.

The first impurity semiconductor layer forming unit process chamber P11' and the second impurity semiconductor layer forming unit process chamber P14' form the first impurity semiconductor layer and the second impurity semiconductor layer respectively. The intrinsic semiconductor layer forming unit process chambers P12' and P13' form the intrinsic semiconductor layer of the second photoelectric converter.

The mask layer forming process chamber PA forms the mask layer by depositing the material of a mask on the second photoelectric converter from the other side obliquely with respect to the surface of the substrate.

As described above, the second photoelectric converter forming unit process chambers P11' to P14' form the second photoelectric converter. Here, the photoelectric converter on which light is first incident among the first photoelectric converter and the second photoelectric converter may be made of a material based on the amorphous silicon in order to sufficiently absorb the light with a short wavelength. Also, the photoelectric converter on which light is later incident may be made of a material based on the microcrystalline silicon in order to sufficiently absorb the light with a long wavelength. Therefore, when the integrated solar cell manufactured by the manufacturing apparatus according to the embodiments of the present invention is a pin type solar cell, the first photoelectric converter may include a p-type semiconductor layer, an intrinsic amorphous silicon semiconductor layer, and an n-type semiconductor layer which have been sequentially stacked. The second photoelectric converter may include a p-type semiconductor layer, an intrinsic microcrystalline silicon semiconductor layer, and an n-type semiconductor layer.

Furthermore, when the integrated thin film solar cell manufactured by the manufacturing apparatus according to the embodiments of the present invention is a nip type solar cell, the first photoelectric converter may include an n-type semiconductor layer, an intrinsic microcrystalline silicon semiconductor layer, and a p-type semiconductor layer which have been sequentially stacked. The second photoelectric converter may include an n-type semiconductor layer, an intrinsic amorphous silicon semiconductor layer, and a p-type semiconductor layer.

In consideration of the characteristics or manufacture efficiency of the solar cell, the p-type semiconductor layer of the first photoelectric converter or the second photoelectric converter may be a semiconductor layer based on p-type amorphous silicon or a semiconductor layer based on p-type microcrystalline silicon. Also, the n-type semiconductor layer of the first photoelectric converter or the second photoelectric converter may be a semiconductor layer based on n-type amorphous silicon or a semiconductor layer based on n-type microcrystalline silicon. By using the inline type integrated thin film solar cell manufacturing apparatus in a roll-to-roll method or in a roller method shown in Fig. 3, on the substrate where the trenches have been formed separately from each other, a series of processes including the formation of the first conductive layer by the oblique deposition, the formation of the first photoelectric converter, the formation of the second photoelectric converter, the formation of the mask layer by the oblique deposition, the etching of the second photoelectric converter, the etching of the first photoelectric converter, and the formation of the second conductive layer by the oblique deposition, etc., are continuously performed in vacuum. As a result, the integrated high efficiency thin film solar cell with a double-junction structure is manufactured in vacuum without using laser.

As described with reference to the first embodiment, when the first photoelectric converter and the second photoelectric converter are formed in the photoelectric converter forming process chamber P1 by using the above-described thin film deposition method such as sputtering, ion-beam evaporation, neutral particle beam evaporation, electron beam evaporation, thermal evaporation, an effusion cell, spray, etc., which uses the straightness of a deposition material, the material of the photoelectric converter may be obliquely deposited on the substrate in such a manner that a portion of the first conductive layer located within the trench is exposed. Therefore, since there is no need to etch the material of the photoelectric converter after the formation of the mask layer, the mask layer forming process chamber PA and the etching process chamber EP can be omitted. In this case, on the substrate where the trenches have been formed separately from each other at a regular interval and in parallel with each other, the formation of the first conductive layer, the formation of the first photoelectric converter and the second photoelectric converter, and the formation of the second conductive layer are performed in turn. Accordingly, adjacent cells are electrically connected in series to each other, so that the integrated high efficiency thin film solar cell with a double-junction structure is manufactured.

As described above, in the manufacture of the integrated solar cell by the inline type in a roll-to-roll method or in a roller method according to the third embodiment of the present invention, it is possible to manufacture the integrated high efficiency thin film solar cell which has a multi-junction structure and maximizes the effective area by performing repeatedly or continuously only a deposition process in the plurality of vacuum process chambers.

Fig. 4 shows an integrated thin film solar cell manufacturing apparatus according to a modified example of the first embodiment of the present invention and shows an inline type manufacturing apparatus in a cluster method.

Meanwhile, the integrated thin film solar cell manufacturing apparatus shown in Fig. 4 includes the photoelectric converter forming process chamber P1 including one or more unit process chambers P11, P12, P13, and P14, the mask layer forming process chamber PA, the etching process chamber EP, the second electrode layer forming process chamber P2, the first electrode layer forming process chamber P3, and the loading/unloading chamber LP/ULP. The functions of the chambers are the same as those described in the first embodiment respectively. Therefore, a detailed description thereof will be omitted.

As shown in Fig. 4, unlike the first embodiment, the integrated thin film solar cell manufacturing apparatus according to a modified example of the first embodiment of the present invention is an inline type manufacturing apparatus in a rectangular cluster method. In the integrated thin film solar cell manufacturing apparatus of Fig. 1, the process chambers are arranged radially around the transfer chamber TC. In the integrated thin film solar cell manufacturing apparatus of Fig. 4, the process chambers are arranged on both long sides of the rectangular transfer chamber TC. The loading/unloading chamber LP/ULP which combines the functions of loading and unloading the substrate, one or more unit process chambers P11 to P14, the mask layer forming process chamber PA, the etching process chamber EP, and the second conductive layer forming process chamber P2 are uniformly installed on one and the other of the long sides of the rectangular transfer chamber TC. The transfer part 40 such as a transfer robot is installed within the transfer chamber TC and transfers the substrate (not shown) in vacuum from one chamber to another chamber. Rails 30 through which the transfer part 40 moves are installed on the bottom of the transfer part 40. The transfer part 40 transfers the substrate to the insides of the unit process chambers P11 to P14, the mask layer forming process chamber PA, the etching process chamber EP, and the second conductive layer forming process chamber P2 by moving along the rails 30.

A first member 41 and a second member 43 are coupled to the top of the transfer part 40 by coupling means 44 and 45 respectively. The first member 41 is able to linearly reciprocate along the rail 30 installed on the inner bottom of the transfer chamber TC and is also able to rotate about the coupling means 44 and 45 clockwise or counterclockwise and able to vertically reciprocate. Also, the second member 43 capable of linearly reciprocating on the first member 41 is installed as coupled with the top of the first member 41 by a coupling and linear drive means 42. Both ends of the second member has a structure (not shown) allowing the substrate to be placed thereon without sliding.
The substrate placed on the second member 43 within the loading/unloading chamber LP/ULP may be transferred to the inside of at least one of the plurality of process chambers P11 to P14, PA, EP, and P2 by the operation of the transfer part 40, the first member 41, and the second member 43.

While Fig. 4 shows one loading/unloading chamber LP/ULP, there is no limit to this. The loading chamber LP and the unloading chamber ULP may be connected separately to the transfer chamber. Also, the loading chamber LP and the unloading chamber ULP may further include the substrate holder which receives the substrate from the transfer part 40. Also, the loading/unloading chamber LP/ULP may be installed on one of the short sides of the rectangular transfer chamber. The loading chamber LP and the unloading chamber ULP may be installed separately on both short sides of the rectangular transfer chamber respectively. However, various installations can be made without being limited to the chamber installations.

In the cluster type manufacturing apparatus of Fig. 4, when the lengths of the long sides of the transfer chamber TC are increased and the number of the process chambers which deposit or etch the first conductive material, the material for a mask, the second conductive material, and the photoelectric conversion material on both long sides of the transfer chamber TC is increased, the enlarged inside of the transfer chamber TC is divided into a certain space and one transfer part 40 is installed in each of the spaces, and then the transfer parts 40 are allowed to transmit and receive the substrate with each other through the second member 43. As a result, the productivity of the integrated thin film solar cell can be significantly improved.

In the integrated thin film solar cell manufacturing apparatuses according to the first embodiment and the fourth embodiment of the present invention, it has been described that the first conductive layer forming process chamber P3, the photoelectric converter forming process chamber P1, the mask layer forming process chamber PA, and the second conductive layer forming process chamber P2 are separated apart from each other. However, the functions of the above four process chambers can be replaced by using at least one process chamber among these process chambers.

Figs. 5a to 5e show an example of the manufacturing process of the integrated thin film solar cell which is manufactured by the integrated thin film solar cell manufacturing apparatuses of Figs. 1 to 4.

The trenches 101 and 102 are, as shown in Fig. 5a, formed in the surface of the substrate 100 which is used in the manufacture of the integrated thin film solar cell. The width of the trench is several tens of micron. It is desirable that a ratio of the depth to the width of the trench should be 1. Considering that the width of the area lost by an existing laser patterning is several hundreds of micron, it can be seen that the loss of the effective area can be very effectively reduced by the present invention. The substrate 100 may be made of a transparent material or an opaque material in accordance with the structure of the solar cell. When the solar cell has a superstrate type structure, i.e., a structure on which light can be incident through the substrate 100, the substrate 100 may be made of a transparent insulating material having high optical transmittance. For example, the substrate 100 may be one of a glass substrate made of sodalime glass, tempered glass, etc., a plastic substrate, or a nano composite substrate. The nano composite is a system in which nanoparticles are dispersed in a dispersive medium (matrix, continuous phase) in a dispersed phase. The dispersive medium may be an organic solvent, plastic, metal or ceramic. The nanoparticle may be plastic, metal or ceramic. When the dispersive medium is the organic solvent, the organic solvent is removed by a heat treatment process and then the nanoparticles only may remain.
When the solar cell has a substrate type structure, i.e., a structure on which light is not incident through the substrate 100 and is incident through a transparent conductive layer or thin metal facing the incident light, the substrate 100 may be made of a ceramic or a metallic material. Even in this case, the substrate 100 may be made of glass, plastic, or nano composite. Here, the ceramic, glass, plastic, and nano composite may include a thermosetting material or a UV curable material. During a process of forming a thin plate or a thin film in a state where a material such as glass, ceramic, metal, plastic, a nano composite, etc., has been melted, before the material is solidified, the straight trenches 101 and 102 which are spaced apart from each other at a regular interval and in parallel with each other may be formed in the substrate by imprinting, pressing, embossing, thermal solidifying, ultra-violet (UV) solidifying, etc. In the case of a conductive substrate such as metal, an insulating material such as plastic, ceramic, a nano composite, etc., is coated on the entire surface of the substrate after the trench is formed, or otherwise, after the insulating material is coated on the surface of the conductive layer, the trench is formed in the insulating material by the above-described methods. Also, the trench may be formed in an insulation substrate like glass by the above-described methods. Also, without melting the substrates, the trenches 101 and 102 may be formed in the substrate by using a hot-embossing method or a hot-pressing method. In this case, the trench is formed in the thin film made of the plastic, ceramic, or nano composite and coated on the glass or on the metallic substrate. Therefore, it is possible to more easily form the trench than to form directly the trench on the glass or on the metallic substrate.

Also, the trenches 101 and 102 may be formed not only by pressing, hot-pressing, embossing, or the hot-embossing by an uneven mold of which the surface has unevenness for forming the trenches therein, but by any one of wet etching, dry etching, a mechanical process such as grinding and cutting, or an optical processing such as laser scribing. More simply, the trenches may be formed in the substrate by using a fine string or wire like a guitar string and a flat mold having a flat surface.

The foregoing kinds of the substrate and trench forming methods can be commonly applied to the embodiments of the present invention.

As shown in Fig. 5a, in the first conductive layer forming process chamber P3 of the integrated thin film solar cell manufacturing apparatus of Figs. 1 to 4, the first conductive material is obliquely deposited (OD1) from one side at a maximum angle of θ1 on the substrate 100 where the trenches have been formed separately from each other at a regular interval and in parallel with each other, so that the first conductive layer 110 is formed.

Accordingly, due to the straightness of the deposition material, the first conductive material is deposited from one basic line within each of the trenches 101 and 102 of the substrate 100 to the bottom of each of the trenches, to one side continuous from the bottom, and to a protruding surface of the substrate, which is continuous from the one side, so that the first conductive layers 110 spaced apart from each other are formed. That is to say, due to a correlation between the oblique deposition angle θ1 and the cross section shapes of the trenches 101 and 102 formed in the substrate 100, the first conductive material is not deposited on a portion of the inner walls of the trenches 101 and 102. Here, it is premised that the deposition angle is measured based on the flat protruding surface of the substrate.

In Fig. 5a, the first conductive layer 110 is formed in the first conductive layer forming process chamber P3 of the integrated thin film solar cell manufacturing apparatus. However, the substrate 100 where the first conductive layers 110 spaced apart from each other have been already formed may be loaded into the loading chamber LP and may be transferred to the inside of any one unit process chamber of the photoelectric converter forming process chamber P1 by the transfer part 40. In this case, the integrated thin film solar cell manufacturing apparatus may not include the first conductive layer forming process chamber P3.

As shown in Fig. 5b, the photoelectric converter forming process chamber P1 including the unit process chambers P11 to p14 of the integrated thin film solar cell manufacturing apparatus of Figs. 1 to 4 forms the photoelectric converter 120. The photoelectric converter 120 is formed on the substrate where the first conductive layer 110 has been formed. Here, when the photoelectric converter forming process chamber P1 of the integrated thin film solar cell manufacturing apparatus includes the unit process chambers P11' to P14' forming the second photoelectric converter as well as the unit process chambers P11 to p14 forming the first photoelectric converter, the integrated thin film solar cell with a multi-junction structure may be manufactured.

As shown in Fig. 5c, in the mask layer forming process chamber PA of the integrated thin film solar cell manufacturing apparatus shown in Figs. 1 to 4, the mask 130 is formed by depositing the material for a mask on the substrate where the photoelectric converter 120 has been formed. Specifically, the material for a mask is deposited (OD2) from the other side obliquely at a maximum angle θ2 with respect to the substrate, so that the mask layer is formed. Here, the other side means the opposite side to one side from which the first conductive material is deposited. The material for a mask is obliquely deposited on the surface at the angle of θ2. Therefore, due to the straightness of the deposition material, the material for a mask is not deposited on a portion of the photoelectric converter 120 formed within the trenches 101 and 102. The mask layer 130 may be used as a mask for etching in the etching process chamber EP. When the mask layer 130 is made of a transparent conductive material in the cluster type manufacturing apparatus of Figs. 1 and 4, the mask layer 130 may be, as described above, formed in the first conductive layer forming process chamber P3, instead of the mask layer forming process chamber PA. That is to say, when the mask layer 130 and the first conductive layer 110 are made of the same material, the mask layer130 may be formed in the process chamber P3 where the first conductive layer 110 is formed. Also, even when the mask layer 130 and the first conductive layer 110 are made of different materials, the emitter 300 and the deposition angle adjuster 400 which are for forming the mask layer 130 as well as the emitter 300 and the deposition angle adjuster 400 which are for forming the first conductive layer 130 are installed in the process chamber P3 where the first conductive layer 110 is formed, so that the mask layer 130 may be formed in the first conductive layer forming process chamber P3. Here, while the first conductive material is deposited obliquely from one side at a maximum angle of θ1 with respect to the substrate, the material for a mask is deposited obliquely from the opposite side to the one side, i.e., the other side at a maximum angle of θ2. Through such a process, the etched area of the photoelectric converter 120 is limited.

As shown in Fig. 5d, in the etching process chamber EP of the integrated thin film solar cell manufacturing apparatus shown in Figs. 1 to 4, the photoelectric converter 120 is vertically etched by using the mask layer 130 as a mask such that a portion of the first conductive layer 110 covered with the photoelectric converter within the trenches 101 and 102 is exposed. Here, it is desirable to use a dry etching process such as reactive ion etching (RIE) using inductively coupled plasma (ICP). However, there is no limit to this.

As shown in Fig. 5e, in the second conductive layer forming process chamber P2 of the integrated thin film solar cell manufacturing apparatus shown in Figs. 1 to 4, the second conductive material is deposited (OD3) obliquely from the other side on the photoelectric converter 120 with respect to the surface of the substrate at a maximum angle of θ3 greater than the maximum angle of θ2, such that the first conductive layer 110 formed in one unit cell area UC1 is electrically connected within the trench to the second conductive layer 130 formed in another unit cell area UC2 adjacent to the unit cell area UC1. As a result, the second conductive layer 140 is formed which electrically connects in series the adjacent unit cells.

As described above, the trench may be formed in the area between the adjacent photoelectric converters 120, and the photoelectric converters 120 located on both sides of the trench may be the unit cell areas UC1 and UC2 adjacent to each other. When the second conductive material is deposited (OD3) obliquely from the other side with respect to the substrate at a maximum angle of θ3 greater than the maximum angle of θ2, the first conductive layer 110 and the second conductive layer 130, which has been exposed by the etching, are electrically connected to each other, due to the straightness of the deposition material. As a result, the adjacent cells are electrically connected in series to each other, so that the integrated high efficiency thin film solar cell is manufactured.

As described above, in the manufacture of the integrated thin film solar cell by the embodiments of the present invention, a deposition process and an etching process are performed repeatedly or continuously in the plurality of vacuum process chambers, so that the integrated high efficiency thin film solar cell which has a single-junction structure and the maximized effective area can be manufactured in vacuum.

Also, when the photoelectric converter is formed in the photoelectric converter forming process chamber P1 by using the above-described thin film deposition method such as sputtering, ion-beam evaporation, neutral particle beam evaporation, electron beam evaporation, thermal evaporation, an effusion cell, spray, etc., which uses the straightness of a deposition material, the material of the photoelectric converter may be obliquely deposited on the substrate in such a manner that a portion of the second conductive layer located within the trench is exposed. Therefore, since there is no need to etch the material of the photoelectric converter after the formation of the mask layer, the processes shown in Figs. 5c and 5d can be omitted. In summary again, when the photoelectric converter is formed by obliquely depositing the material of the photoelectric converter, on the substrate where the trenches have been formed separately from each other at a regular interval and in parallel with each other, the formation of the first conductive layer, the formation of the photoelectric converter, and the formation of the second conductive layer are performed in turn. Accordingly, adjacent cells are electrically connected in series to each other, so that the integrated high efficiency solar cell with a single-junction structure is manufactured.

As described above, in the manufacture of the integrated thin film solar cell by the embodiment of the present invention, it is possible to manufacture the integrated high efficiency solar cell which has a multi-junction structure and maximizes the effective area by performing repeatedly or continuously only a deposition process in the plurality of vacuum process chambers.

Also, the above-described processes (Figs. 5a, 5b, 5c, 5d, and 5e or Figs. 5a, 5c, and 5e) are performed in the same manner by using the substrate having a lot of holes formed therein which are blocked by or pass through the unit cell areas UC1 and UC2 of the substrate, that is, the protruding surface areas, an integrated see-through type thin film solar cell can be manufactured very inexpensively (see US Patent Number 8,449,782, Japanese Patent Number 4,592,676, and Japanese Patent Number 5,396,444).

Figs. 6a to 6b show an example of the second conductive layer forming process chamber P2 of the integrated thin film solar cell manufacturing apparatus according to the embodiments of the present invention. The second conductive material is obliquely deposited in the process chamber P2 shown in Figs. 6a and 6b by using the thin film deposition method such as sputtering, ion-beam evaporation, neutral particle beam evaporation, electron beam evaporation, thermal evaporation, an effusion cell, spray, etc., which uses the straightness of a deposition material. Furthermore, as described above, the material for a mask, the first conductive material, and the material of the photoelectric converter may be also obliquely deposited. Hereinafter, described is a case in which the second conductive material is obliquely deposited.

The process chamber P2 forming the second conductive layer 140 includes the substrate holder 200, the emitter 300, and the deposition angle adjuster 400. The substrate holder 200 receives the substrate 100 from the transfer part 40. That is, the substrate holder 200 is installed in the lower portion of the inside of the second conductive layer forming process chamber P2, and receives and supports the substrate 100. The substrate 100 is transferred to the inside of the process chamber P2 by the transfer part (not shown) through an inlet (not shown) formed in one side of the second conductive layer forming process chamber P2. The substrate 100 supported by the substrate holder 200 may move right and left along rails 230 by wheels 210 installed on the bottom of the substrate holder 200.

As described above, the inline type integrated thin film solar cell manufacturing apparatus in a roll-to-roll method or in a roller method may not include the transfer chamber TC equipped with the transfer part 40. Therefore, the second conductive layer forming process chamber P2 of the inline type manufacturing apparatus may not include the rail 230 and the substrate holder 200 receiving the substrate 100 from the transfer part 40.

The emitter 300 emits the second conductive material toward the substrate 100. The emitter 300 is disposed over the substrate holder 200 and emits the second conductive material to be deposited on the substrate 100. The conductive material 310 to be deposited is filled in the emitter 300. When a deposition process is performed by thermal evaporation, a heating means (not shown) for evaporating the conductive material by heating the emitter 300 may be further provided at the outside of the emitter 300. While the second conductive material deposition process may be performed by ion beam evaporation or neutral particle beam evaporation, the material to be evaporated within the emitter 300 is heated through the collision with electron beam, ion beam, or neutral particle beam, so that the second conductive material may be emitted from the emitter 300. Also, the emitter 300 can emit not only the conductive material but an insulating material and semiconductor material, i.e., the material of the photoelectric converter.

The deposition angle adjuster 400 blocks a portion of the second conductive material being emitted, such that the second conductive layer 140 which is electrically connected to the first conductive layer 110 is formed in an area between the adjacent photoelectric converters 120 formed on the mask layer 130. For this purpose, the deposition angle adjuster 400 of Fig. 6a surrounds the emitter 300, and the cylindrical surface of the deposition angle adjuster 400 has one or more openings 410 and 420 through which the second conductive material is emitted toward the substrate 100. Here, the second conductive material may be provided to the emitter 300 through the upper opening 410 of the deposition angle adjuster 400 among the openings from an exterior conductive material provider (not shown), or may be continuously provided from one side or both sides of the deposition angle adjuster 400. The second conductive material is emitted toward the substrate 100 at a desired angle through the opening 420 adjacent to the substrate holder 200. The deposition angle adjuster 400 may be formed from a circular or other shaped plate surrounding the emitter 300. Also, the deposition angle adjuster 400 may be connected to an exterior actuator (not shown) and rotate in order to adjust the angle at which the second conductive material is emitted toward the substrate 100. Accordingly, the deposition angle adjuster 400 is rotated at a suitable angle, and thus, the deposition angles θ and θ' of the conductive material which is deposited on the substrate 100 where the trenches have been formed separately from each other at a regular interval and in parallel with each other can be adjusted. The deposition angle adjuster 400 of Fig. 6a blocks a portion of the second conductive material emitted by the position changes of the openings 410 and 420, so that the positive (+) deposition angles θ and θ' or negative (-) deposition angles -θ and -θ' are controlled. The deposition angle adjuster 400 of Fig. 6b includes a flat plate and blocks a portion of the second conductive material emitted by the right and left movements of the flat plate. For example, as shown, when the deposition angle adjuster 400 moves to the left, the positive deposition angle θ' of the second conductive material may become smaller, and when the deposition angle adjuster 400 moves to the right, the deposition angle θ of the second conductive material may become larger. When the deposition angle adjuster 400 further moves to right, the negative deposition angles -θ and -θ' can be adjusted. As described above, the deposition angle adjuster may be a partition between the emitters or between the process chambers or may be a portion of the structure of the process chamber. Therefore, in the latter case, there is no necessity of the device, the part, the partition, etc., which has a function of the shutter.

Though not shown in Figs. 6a and 6b, the second conductive layer forming process chamber P2 may further include a shutter disposed under the deposition angle adjuster 400. The shutter is closed early in an emission process in order to prevent that oxides or pollutants attached to the surface of the emitter 300 or the second conductive material are emitted together with the second conductive material and are deposited on the substrate 100. When the shutter is opened with a predetermined lapse of time, the pure conductive material begins to be emitted toward the substrate 100. Also, the deposition angle adjuster 400 of Figs. 6a and 6b may include a cooling pipeline 430 cooling the deposition angle adjuster 400. The cooling pipeline 430 may be located on the surface of the deposition angle adjuster 400. By cooling the deposition angle adjuster 400, the conductive material attached to the surface of the deposition angle adjuster 400 or to the edge of the opening 420 is prevented from flowing down or being emitted again, so that the conductive material can be emitted only in a desired direction.

The thickness of the second conductive layer 140 formed at the minimum deposition angle θ' may be relatively less than the thickness of the second conductive layer 140 formed at the maximum deposition angle θ. For the purpose of solving such a problem, when the substrate holder 200 or the substrate placed on the rail 230 is moved right and left at a constant speed or only in one direction, the uniform second conductive layer with a suitable thickness can be formed on the substrate 100. When a flexible substrate is used in the manufacturing apparatus in a roll-to-roll method or in a roller method, a uniform film can be deposited in the same manner.

Meanwhile, Figs. 6a and 6b show that the substrate holder 200 is installed in the lower portion of the inside of the second conductive layer forming process chamber P2 and is disposed under the substrate 100. However, there is no limit to this. The substrate holder 200 may be installed in the upper portion of the second conductive layer forming process chamber P2 and may support the substrate 100 at the top of the substrate 100. The manufacturing apparatus in a roll-to-roll method or in a roller method may not require the substrate holder.

The substrate holder 200, the emitter 300, and the deposition angle adjuster 400 of the second conductive layer forming process chamber P2 may be included in all of the process chambers where the oblique deposition is performed. That is, as shown in Figs. 5a and 5c, the first conductive layer 110 and the mask layer 130 are by the oblique deposition. Accordingly, the process chamber P3 and the mask layer forming process chamber PA, which form the first conductive layer 110 and the mask layer 130, may include the substrate holder 200, the emitter 300, and the deposition angle adjuster 400, respectively. The emitter 300 of the first conductive layer forming process chamber P3 may emit the first conductive material, and the emitter 300 of the mask layer forming process chamber PA may emit the material for a mask. Also, though not shown, as described above, the photoelectric converter may be also formed by the oblique deposition. Accordingly, the unit process chambers P11, P12, P13, and P14 of the photoelectric converter forming process chamber P1 may include the substrate holder 200, the emitter 300, and the deposition angle adjuster 400, respectively. The emitters 300 of the unit process chambers P11, P12, P13, and P14 of the photoelectric converter forming process chamber P1 may emit a photoelectric converter forming material. Accordingly, the first conductive material, the material of the photoelectric converter, the material for a mask, or the second conductive material may be obliquely deposited on the surface of the substrate.

As described above, the integrated thin film solar cell manufacturing apparatuses according to the embodiments of the present invention commonly include the second conductive layer forming process chamber P2 which includes the transfer part 40 transferring in vacuum the substrate where the first conductive layers 110 spaced apart from each other and the photoelectric converters 120 spaced apart from each other have been sequentially stacked, the substrate holder 200 receiving the substrate 100 from the transfer part, the emitter 300 emitting the second conductive material toward the substrate 100, and the deposition angle adjuster 400 adjusting the direction of the second conductive material such that the second conductive layer 140 electrically connected to the first conductive layer 110 is formed in the area between the adjacent photoelectric converters 120.

Also, though not shown in Figs. 1 to 4, the integrated thin film solar cell manufacturing apparatus according to the embodiments of the present invention may further include a process chamber which forms the trenches in the substrate by a method such as nano-imprinting, hot embossing, hot pressing, etc. Also, a drying or cooling process chamber for drying or cooling the substrate having the trenches formed therein after the trenches are formed may be further included. The drying or cooling process chamber of Figs. 1 and 4 is mounted around the transfer chamber, and the drying or cooling process chamber of Figs. 2 and 3 is mounted between the loading chamber LP and the process chamber P3 forming the first conductive layer. At this time, the substrate where the trenches have not been formed and the flexible substrate are loaded into the loading chamber LP respectively.

Also, though not shown in Figs. 1, 2, and 4, the integrated solar cell manufacturing apparatus according to the embodiments of the present invention may further include, as shown in Fig. 3, the unit process chambers P11' to P14' forming the second photoelectric converter as well as the unit process chambers P11 to P14 forming the first photoelectric converter. When the second photoelectric converter is formed on the first photoelectric converter, a process chamber for forming an intermediate layer located between the first photoelectric converter and the second photoelectric converter may be further included. Accordingly, the integrated solar cell with a double-junction structure can be manufactured.

The intermediate layer is made of an insulating material or a conductive material. A transparent material can be used as the material of the intermediate layer. For example, the intermediate layer may include at least any one of silicon nitride, silicon oxide, silicon carbide or metal oxide. Also, the intermediate layer may include at least one of a metal or an insulator such as cesium (Cs), lithium fluoride (LiF), etc., and metal oxide based materials such as zinc oxide (ZnO), tin oxide (SnO₂), indium tin oxide (ITO), tungsten oxide (WO₃), molybdenum oxide (MoO₃), vanadium oxide (V₂O₅), titanium oxide (TiOₓ), nickel oxide (NiOₓ), etc.
Also, though not shown in Figs. 1 to 4, in the integrated thin film solar cell manufacturing apparatus according to the embodiments of the present invention, an opening-closing means, a sealing means, and an isolating means such as a gate valve, a gas gate, or a partition may be installed respectively in order that the conductive material or process gas or etching gas for forming the photoelectric converter may not be mixed with each other between the process chambers. Also, though not shown, the gate valve, gas gate, partition, etc., may be disposed respectively between the transfer chamber and the each of the process chambers EP, PA, and P2 connected to the transfer chamber or between the unit process chambers P11 to P14 in Figs. 1 and 4 or between all adjacent process chambers from the loading chamber LP to the unloading chamber in Figs. 2 and 3.

Also, though not shown, each of all of the process chambers may include a means for cooling or heating the substrate if necessary.
It has been described that a material to be deposited is incident at an oblique angle with respect to the surface of the substrate within the process chambers P3, P1, PA, EP, and P2 of the integrated thin film solar cell manufacturing apparatuses according to the embodiments of the present invention, so that the thin film is formed on the substrate. However, depending on the cross section shape of the trench formed in the substrate, for example, when the cross section shape is the same as that of an inclined well, the thin film is not necessarily need to be formed within the respective process chambers by the oblique deposition, and the thin film may be formed by vertical deposition with respect to the substrate (see Korean Patent No. 10-1060239 and Korean Patent No. 10-1112487).

Up to now, the term "oblique deposition" has been used to mean that when the substrate where the trenches have been formed separately from each other and in parallel with each other is placed horizontally, a material to be deposited is incident at an oblique angle with respect to the surface of the substrate and is deposited on the substrate. However, this oblique deposition is a relative concept and may include a case where the material to be deposited is vertically incident with respect to a horizontal plane, and in response to this, the substrate is obliquely placed with respect to the horizontal plane or moves with respect to the horizontal plane. Also, the oblique deposition can be also applied to a case where the substrate is hard like glass or is flexible like polymer. For example, the oblique deposition can be applied not only to the roll-to-roll type manufacturing apparatus but also, as used above several times, to the roller type manufacturing apparatus. While the embodiment of the present invention shows that the process chambers are arranged in a straight line in Figs. 2 and 3, the arrangement of the process chambers is slightly changed into a circular arrangement, and thus, the roller type manufacturing apparatus is obtained. In other words, one large drum is used and all of the process chambers or process means (emitter) are arranged along the outer circumference of the drum. In this case, since the flexible substrate moves contacting the surface of the large drum and various process means are arranged around the drum, a relative incident angle at which a process material is incident with respect to the flexible substrate can be freely adjusted. The oblique deposition can be realized by using an isolating means such as a partition, etc., in some cases and by relatively tilting the emitter with respect to the substrate at an arbitrary angle. Also, the oblique deposition can be applied to the cluster type, roll-to-roll type or roller type manufacturing apparatus capable of processing the substrate by horizontally placing the substrate or by vertically or horizontally standing up the substrate.

Also, Figs. 1 to 4 and the description related to Figs. 1 to 4 show that the process chambers included in the manufacturing apparatus according to the embodiments of the present invention are independent. However, each of the process chambers does not necessarily include its own sealed space as described in the roller type apparatus. For example, when each layer of the solar cell according to the embodiments of the present invention is deposited and etched, each process space is only required to be isolated by a means such as a partition, etc., in order to prevent the deposition materials and the etching materials in different processes from being mixed with each other. As described above, each process space may be located in one vacuum chamber. Therefore, in the present specification, the process chamber may be designated to include not only its own sealed space but also an independent space isolated or shielded by the isolating means or a portion of the structure of the process chamber, etc.

The foregoing has described that the integrated thin film solar cell including the silicon based photoelectric conversion material is manufactured by the integrated thin film solar cell manufacturing apparatuses according to the embodiments of the present invention. However, there is no limit to this. The integrated thin film solar cell manufacturing apparatus according to the embodiments of the present invention can be applied to the manufacture of the solar cells including a compound based photoelectric conversion material, an organic based photoelectric conversion material, a dry-type dye-sensitized based photoelectric conversion material, and a perovskite based photoelectric conversion material. Also, the number of the process chambers can be controlled according to the material constituting the photoelectric converter or according to the use of the photoelectric converter.

In the manufacture of the integrated thin film solar cell by the manufacturing apparatuses according to the embodiments of the present invention, the laser etching process, etc., are not required, so that there is no opportunity to expose the substrate to the air during the process. Therefore, since the integrated thin film solar cell is manufactured in a state where vacuum is always maintained, film characteristics are prevented from being deteriorated by various impurities, thereby improving the performance of the integrated thin film solar cell.

Accordingly, the integrated thin film solar cell manufacturing apparatuses according to the embodiments of the present invention is able to fundamentally prevent contamination caused by dust or the deterioration of the film characteristics, which is caused during a laser patterning process. Also, a process of inverting and cleaning the substrate in order to reduce or remove the dust caused by the laser patterning process can be omitted.

In the integrated thin film solar cell manufacturing apparatuses according to the embodiments of the present invention, the vacuum state can be maintained when the device with a single-junction structure is manufactured by electrically connecting in series the unit cells. Furthermore, the manufacturing apparatuses according to the embodiments of the present invention are also able to maintain the vacuum state even when the integrated thin film solar cell with a multi-junction structure is manufactured.

As such, it can be understood by those skilled in the art that technical configurations of the present invention can be embodied in other specific forms without changing its spirit or essential characteristics of the present invention.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

### Industrial Applicability

As stated above, according to the embodiment of the present invention described above, it is possible to manufacture an integrated thin film solar cell which maximizes the effective area by performing repeatedly or continuously only a deposition process in a plurality of vacuum process chambers or by performing repeatedly or continuously the deposition process and an etching process in the plurality of vacuum process chambers, thereby maximizing the electric power production.

According to the embodiment of the present invention, it is possible to manufacture the integrated thin film solar cell with a multi-junction structure as well as a single-junction structure in the plurality of vacuum process chambers.

According to the embodiment of the present invention, it is possible to manufacture the integrated thin film solar cell which has a high efficiency without breaking the vacuum in order to fundamentally solve a problem that, whenever a substrate on which each thin film has been deposited is exposed to the air so as to perform a laser patterning process, each layer of the solar cell is contaminated by moisture, dust, etc., in the air, so that the interface properties of a device are deteriorated, and thus, the energy conversion efficiency of the device is degraded.

According to the embodiment of the present invention, it is possible to manufacture the integrated thin film solar cell which has a high efficiency without using laser in order to fundamentally solve a problem that fine holes, i.e., pin holes are formed in the thin film by the dust generated by the laser scribing, so that then a shunt resistance is reduced, and the thin film is thermally damaged by the laser energy, so that the film characteristics are deteriorated and the junction characteristics of the device are deteriorated, and thus, the energy conversion efficiency of the device is degraded.

According to the embodiment of the present invention, it is possible to manufacture the integrated high efficiency thin film solar cell which has a low manufacturing cost even without a substrate inverter, a substrate cleaner, and several expensive laser apparatuses for the purpose of the countermeasures against the dust.

According to the embodiment of the present invention, it is possible to manufacture the integrated see-through type thin film solar cell even without using an expensive laser apparatus.

## Claims

1. An apparatus for manufacturing an integrated thin film solar cell in which a plurality of unit cells are electrically connected in series to each other in vacuum, the apparatus comprising:
a photoelectric converter forming process chamber which forms a photoelectric converter by emitting a photoelectric conversion material on a substrate where a first conductive layer has been formed from one basic line within each of a plurality of trenches formed in the substrate to a bottom of each of the trenches, to one side continuous from the bottom, and to a protruding surface of the substrate, which is continuous from the one side; and
a second conductive layer forming process chamber which forms a second conductive layer from another basic line within each of the trenches to the bottom of each of the trenches, to the other side continuous from the bottom, and to a protruding surface of the substrate, which is continuous from the other side,
wherein the photoelectric converter forming process chamber and the second conductive layer forming process chamber perform the respective processes in vacuum.

2. The integrated thin film solar cell manufacturing apparatus of claim 1, wherein the photoelectric converter forming process chamber and the second conductive layer forming process chamber respectively comprise an emitter which emits the photoelectric converter forming material and the second conductive layer forming material in such a manner as to have straightness each, thereby causing the materials to be respectively incident with respect to the surface of the substrate at an angle less than a predetermined angle.

3. The integrated thin film solar cell manufacturing apparatus of claim 1,
wherein the photoelectric converter in the photoelectric converter forming process chamber is formed such that a portion of the first conductive layer within each of the trenches is exposed, and wherein the another basic line in the second conductive layer forming process chamber is located within an area where the first conductive layer is exposed.

4. The integrated thin film solar cell manufacturing apparatus of claim 1, wherein at least any one of an opening-closing means, a sealing means, and an isolating means is located between the photoelectric converter forming process chamber and the second conductive layer forming process chamber lest the photoelectric converter forming material and the second conductive layer forming material should be mixed with each other between adjacent chambers or should be introduced into the adjacent chamber.

5. The integrated thin film solar cell manufacturing apparatus of claim 1, wherein the second conductive layer forming process chamber comprises an emitter which emits the second conductive layer forming material in such a manner as to have straightness, thereby causing the material to be incident with respect to the surface of the substrate at an angle less than a predetermined angle.

6. The integrated thin film solar cell manufacturing apparatus of claim 1, further comprising:
a mask layer forming process chamber which forms a mask layer on the photoelectric converter; and
a photoelectric converter etching process chamber which etches the photoelectric converter by using the mask layer as a mask such that a portion of the first conductive layer within each of the trenches is exposed,
wherein the another basic line in the second conductive layer forming process chamber is located within an area where the first conductive layer is exposed.

7. The integrated thin film solar cell manufacturing apparatus of claim 6, wherein at least any one of an opening-closing means, a sealing means, and an isolating means is located between the chambers of each of the photoelectric converter forming process chamber, the mask layer forming process chamber, the etching process chamber, and the second conductive layer forming process chamber lest the photoelectric converter forming material, the mask layer forming material, the etching material, and the second conductive layer forming material should be mixed with each other between adjacent chambers or should be introduced into the adjacent chamber.

8. The integrated thin film solar cell manufacturing apparatus of claim 1 or 6, further comprising a first conductive layer forming process chamber which forms the first conductive layer by depositing a first conductive material on the substrate where the plurality of trenches have been formed.

9. The integrated thin film solar cell manufacturing apparatus of claim 8,
wherein the photoelectric converter forming process chamber, the second conductive layer forming process chamber, and the first conductive layer forming process chamber respectively comprise an emitter which emits the photoelectric converter forming material, the second conductive layer forming material, and the first conductive layer forming material in such a manner as to have straightness each, thereby causing the materials to be respectively incident with respect to the surface of the substrate at a predetermined angle,
and wherein the second conductive layer forming process chamber, the mask layer forming process chamber, the etching process chamber, and the first conductive layer forming process chamber respectively comprise an emitter which emits the second conductive layer forming material, the mask layer forming material, the etching material, and the first conductive layer forming material in such a manner as to have straightness each, thereby causing the materials to be respectively incident with respect to the surface of the substrate at an angle less than a predetermined angle.

10. The integrated thin film solar cell manufacturing apparatus of claim 8, wherein at least any one of an opening-closing means, a sealing means, and an isolating means is located between the chambers of each of the photoelectric converter forming process chamber, the second conductive layer forming process chamber, the mask layer forming process chamber, the etching process chamber, and the first conductive layer forming process chamber lest the photoelectric converter forming material, the second conductive layer forming material, the mask layer forming material, the etching material, and the first conductive layer forming material should be mixed with each other between adjacent chambers or should be introduced into the adjacent chamber.

11. The integrated thin film solar cell manufacturing apparatus of any one of claims 1 to 10, wherein the photoelectric converter forming process chamber comprises a first photoelectric converter forming process chamber forming a first photoelectric converter, and a second photoelectric converter forming process chamber forming a second photoelectric converter, and further comprising an intermediate layer forming process chamber which forms an intermediate layer between the first photoelectric converter and the second photoelectric converter.

12. The integrated thin film solar cell manufacturing apparatus of claim 11,
wherein the photoelectric converter forming process chamber, the second conductive layer forming process chamber, the first conductive layer forming process chamber, and the intermediate layer forming process chamber respectively comprise an emitter which emits the photoelectric converter forming material, the second conductive layer forming material, the first conductive layer forming material, and the intermediate layer forming material in such a manner as to have straightness each, thereby causing the materials to be respectively incident with respect to the surface of the substrate at an angle less than a predetermined angle,
and wherein the second conductive layer forming process chamber, the mask layer forming process chamber, the etching process chamber, the first conductive layer forming process chamber, and the intermediate layer forming process chamber respectively comprise an emitter which emits the second conductive layer forming material, the mask layer forming material, the etching material, the first conductive layer forming material, and the intermediate layer forming material in such a manner as to have straightness each, thereby causing the materials to be respectively incident with respect to the surface of the substrate at an angle less than a predetermined angle.

13. The integrated thin film solar cell manufacturing apparatus of claim 11, wherein at least any one of an opening-closing means, a sealing means, and an isolating means exists between the chambers of each of the photoelectric converter forming process chamber, the second conductive layer forming process chamber, the mask layer forming process chamber, the etching process chamber, the first conductive layer forming process chamber, and the intermediate layer forming process chamber lest the photoelectric converter forming material, the second conductive layer forming material, the mask layer forming material, the etching material, the first conductive layer forming material, and the intermediate layer forming material should be mixed with each other between adjacent chambers or should be introduced into the adjacent chamber.

14. The integrated thin film solar cell manufacturing apparatus of any of claims 1 to 10 or 13, further comprising a loading chamber for putting the substrate in the air into vacuum and an unloading chamber for taking out the substrate to the air from the vacuum.

15. The integrated thin film solar cell manufacturing apparatus of claim 14, wherein the loading chamber comprises an unwinding roller for unwinding the substrate wound on a core, and wherein the unloading chamber comprises a rewinding roller for winding the substrate on another core.

16. The integrated thin film solar cell manufacturing apparatus of claim 14, further comprising a transfer chamber which comprises the loading chamber for putting the substrate in the air into vacuum, the unloading chamber for putting the substrate in the air into vacuum, and a transfer part transferring the substrate in vacuum, or further comprising a transfer chamber which comprises a loading/unloading chamber combining the function of the loading chamber with the function of the unloading chamber, and the transfer part transferring the substrate in vacuum.

17. The integrated thin film solar cell manufacturing apparatus of claim 14, wherein at least one of a heating means for heating the substrate and a cooling means for cooling the substrate is further comprised in each of the process chambers if necessary.

## Amended claims

### Amended claims under Art. 19.1 PCT

**1.** An apparatus for manufacturing an integrated thin film solar cell in which a plurality of unit cells are electrically connected in series to each other in vacuum, the apparatus comprising:
a photoelectric converter forming process chamber which forms a photoelectric converter by emitting a photoelectric conversion material on a substrate where a first conductive layer has been formed from one basic line within each of a plurality of trenches formed in the substrate to a bottom of each of the trenches, to one side continuous from the bottom, and to a protruding surface of the substrate, which is continuous from the one side; and
a second conductive layer forming process chamber which forms a second conductive layer from another basic line within each of the trenches to the bottom of each of the trenches, to the other side continuous from the bottom, and to a protruding surface of the substrate, which is continuous from the other side,
wherein the photoelectric converter forming process chamber and the second conductive layer forming process chamber perform the respective processes in vacuum.

**2.** The integrated thin film solar cell manufacturing apparatus of claim 1,
wherein the photoelectric converter in the photoelectric converter forming process chamber is formed such that a portion of the first conductive layer within each of the trenches is exposed,
and wherein the another basic line in the second conductive layer forming process chamber is located within an area where the first conductive layer is exposed.

**3.** The integrated thin film solar cell manufacturing apparatus of claim 1, wherein at least any one of an opening-closing means, a sealing means, and an isolating means is located between the photoelectric converter forming process chamber and the second conductive layer forming process chamber lest the photoelectric converter forming material and the second conductive layer forming material should be mixed with each other between adjacent chambers or should be introduced into the adjacent chamber.

**4.** The integrated thin film solar cell manufacturing apparatus of claim 1, further comprising:
a mask layer forming process chamber which forms a mask layer on the photoelectric converter; and
a photoelectric converter etching process chamber which etches the photoelectric converter by using the mask layer as a mask such that a portion of the first conductive layer within each of the trenches is exposed,
wherein the another basic line in the second conductive layer forming process chamber is located within an area where the first conductive layer is exposed.

**5.** The integrated thin film solar cell manufacturing apparatus of claim 4, wherein at least any one of an opening-closing means, a sealing means, and an isolating means is located between the chambers of each of the photoelectric converter forming process chamber, the mask layer forming process chamber, the etching process chamber, and the second conductive layer forming process chamber lest the photoelectric converter forming material, the mask layer forming material, the etching material, and the second conductive layer forming material should be mixed with each other between adjacent chambers or should be introduced into the adjacent chamber.

**6.** The integrated thin film solar cell manufacturing apparatus of claim 1 or 4, further comprising a first conductive layer forming process chamber which forms the first conductive layer by depositing a first conductive material on the substrate where the plurality of trenches have been formed.

**7.** The integrated thin film solar cell manufacturing apparatus of claim 6,
wherein the photoelectric converter forming process chamber, the second conductive layer forming process chamber, and the first conductive layer forming process chamber respectively comprise an emitter which emits the photoelectric converter forming material, the second conductive layer forming material, and the first conductive layer forming material in such a manner as to have straightness each, thereby causing the materials to be respectively incident with respect to the surface of the substrate at a predetermined angle,
and wherein the second conductive layer forming process chamber, the mask layer forming process chamber, the etching process chamber, and the first conductive layer forming process chamber respectively comprise an emitter which emits the second conductive layer forming material, the mask layer forming material, the etching material, and the first conductive layer forming material in such a manner as to have straightness each, thereby causing the materials to be respectively incident with respect to the surface of the substrate at an angle less than a predetermined angle.

**8.** The integrated thin film solar cell manufacturing apparatus of claim 6, wherein at least any one of an opening-closing means, a sealing means, and an isolating means is located between the chambers of each of the photoelectric converter forming process chamber, the second conductive layer forming process chamber, the mask layer forming process chamber, the etching process chamber, and the first conductive layer forming process chamber lest the photoelectric converter forming material, the second conductive layer forming material, the mask layer forming material, the etching material, and the first conductive layer forming material should be mixed with each other between adjacent chambers or should be introduced into the adjacent chamber.

**9.** The integrated thin film solar cell manufacturing apparatus of any one of claims 1 to 8,
wherein the photoelectric converter forming process chamber comprises a first photoelectric converter forming process chamber forming a first photoelectric converter, and a second photoelectric converter forming process chamber forming a second photoelectric converter, and further comprising an intermediate layer forming process chamber which forms an intermediate layer between the first photoelectric converter and the second photoelectric converter.

**10.** The integrated thin film solar cell manufacturing apparatus of claim 9,
wherein the photoelectric converter forming process chamber, the second conductive layer forming process chamber, the first conductive layer forming process chamber, and the intermediate layer forming process chamber respectively comprise an emitter which emits the photoelectric converter forming material, the second conductive layer forming material, the first conductive layer forming material, and the intermediate layer forming material in such a manner as to have straightness each, thereby causing the materials to be respectively incident with respect to the surface of the substrate at an angle less than a predetermined angle,
and wherein the second conductive layer forming process chamber, the mask layer forming process chamber, the etching process chamber, the first conductive layer forming process chamber, and the intermediate layer forming process chamber respectively comprise an emitter which emits the second conductive layer forming material, the mask layer forming material, the etching material, the first conductive layer forming material, and the intermediate layer forming material in such a manner as to have straightness each, thereby causing the materials to be respectively incident with respect to the surface of the substrate at an angle less than a predetermined angle.

**11.** The integrated thin film solar cell manufacturing apparatus of claim 9, wherein at least any one of an opening-closing means, a sealing means, and an isolating means exists between the chambers of each of the photoelectric converter forming process chamber, the second conductive layer forming process chamber, the mask layer forming process chamber, the etching process chamber, the first conductive layer forming process chamber, and the intermediate layer forming process chamber lest the photoelectric converter forming material, the second conductive layer forming material, the mask layer forming material, the etching material, the first conductive layer forming material, and the intermediate layer forming material should be mixed with each other between adjacent chambers or should be introduced into the adjacent chamber.

**12.** The integrated thin film solar cell manufacturing apparatus of any of claims 1 to 8 or 11, further comprising a loading chamber for putting the substrate in the air into vacuum and an unloading chamber for taking out the substrate to the air from the vacuum.

**13.** The integrated thin film solar cell manufacturing apparatus of claim 12, wherein the loading chamber comprises an unwinding roller for unwinding the substrate wound on a core, and wherein the unloading chamber comprises a rewinding roller for winding the substrate on another core.

**14.** The integrated thin film solar cell manufacturing apparatus of claim 12, further comprising a transfer chamber which comprises the loading chamber for putting the substrate in the air into vacuum, the unloading chamber for putting the substrate in the air into vacuum, and a transfer part transferring the substrate in vacuum, or further comprising a transfer chamber which comprises a loading/unloading chamber combining the function of the loading chamber with the function of the unloading chamber, and the transfer part transferring the substrate in vacuum.

**15.** The integrated thin film solar cell manufacturing apparatus of claim 12, wherein at least one of a heating means for heating the substrate and a cooling means for cooling the substrate is further comprised in each of the process chambers if necessary.
